# EUROPEAN PATENT SPECIFICATION

(11) **EP 1 081 846 B1**
(45) Date of publication and mention of the grant of the patent: **21.05.2003**
(21) Application number: 00306590.1
(22) Date of filing: 02.08.2000
(51) Int. Cl.: H03B 5/12

(54) **Voltage controled oscillator**
Spannungsgesteuerter Oszillator
Oscillateur commandé en tension

(30) Priority: 31.08.1999 JP 24627799; 11.01.2000 JP 2000002736
(43) Date of publication of application: 07.03.2001
(73) Proprietor: ALPS ELECTRIC CO., LTD., Ota-ku Tokyo 145 (JP)
(72) Inventor: Ikarashi, Yasuhiro, Alps Electric Co., Ltd., Tokyo 145 (JP)
(74) Representative: Kensett, John Hinton

(56) References cited:
- JP-A- 5 055 828
- US-A- 5 440 276

## Description

The present invention relates to a voltage controlled oscillator and, more particularly, to a voltage controlled oscillator which is prevented from generating abnormal oscillation and realizes the smaller number of parts used, in which an oscillation transistor and an amplification transistor are connected in series so as to pass direct currents and a resonance circuit is connected to the collector of the oscillator transistor.

Conventionally known voltage controlled oscillators include: a voltage controlled oscillator (hereinbelow, this will be called a known first voltage controlled oscillator) in which an oscillation transistor and an amplification transistor are connected in series so as to pass direct currents and a resonance circuit is connected to the collector of the oscillation transistor; and a band switching type voltage controlled oscillator (hereinbelow, this will be called a known second voltage controlled oscillator) in which an oscillation transistor and an amplification transistor are connected in series so as to pass direct currents and a resonance circuit is connected to the base of the oscillation transistor. In each of the known first and second voltage controlled oscillators, an oscillation signal outputted from the emitter of the oscillation transistor is supplied to the base of the amplification transistor and an amplified oscillation signal is outputted from the collector of the amplification transistor. Another example of a known oscillator can be found in US 5,440,276. This oscillator includes a cascade connection of an oscillating transistor and an amplifying transistor, an RF choke coil connected in series with a resistor between the bases of the two transistors, and a resonant circuit connected to the base of the oscillating transistor.

In the known first voltage controlled oscillator, an RF (high-frequency) choke inductor is necessary for the collector of the oscillation transistor to which the resonance circuit is connected. Consequently, there is a case that an abnormal oscillation signal of a frequency much lower than the frequency of the oscillation signal is generated. Since an inherent oscillation signal is interfered by the abnormal oscillation signal generated, an abnormal oscillation suppressing circuit for suppressing the generation of the abnormal oscillation signal, specifically, an abnormal oscillation suppressing circuit in which an inductor and a resistor are connected in series is connected to a d.c. circuit provided between the collector of the oscillation transistor and the emitter of the amplification transistor.

In contrast, in the known second voltage controlled oscillator, since the resonance circuit is connected to the base of the oscillation transistor, in a manner similar to the known first voltage controlled oscillator, generation of an abnormal oscillation signal in the collector of the oscillation transistor can be avoided.

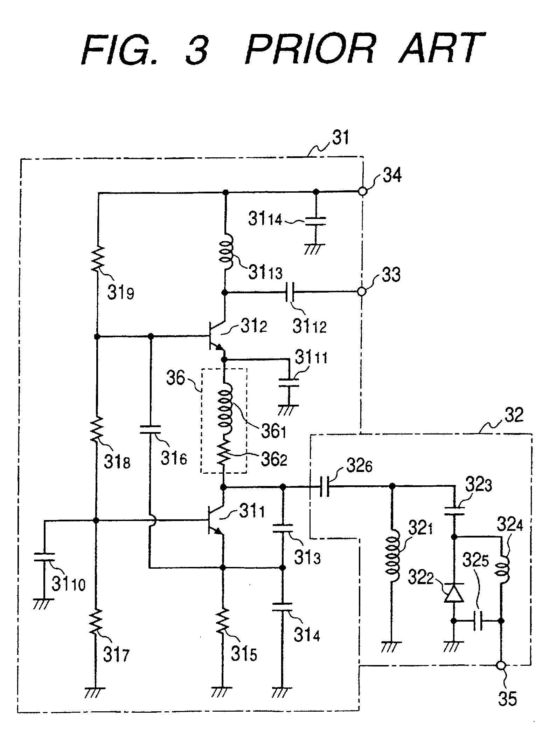

Fig. 3 is a circuit diagram showing an example of the construction of the known first voltage controlled oscillator.

As shown in Fig. 3, the known first voltage controlled oscillator comprises an active circuit section 31 for oscillation, a resonance circuit section 32, an oscillation signal output terminal 33, a power supply terminal 34, a frequency setting voltage supply terminal 35 and an abnormal oscillation suppressing circuit 36.

In this case, the active circuit section 31 for oscillation comprises a first transistor (oscillation transistor) 31₁, a second transistor (amplification transistor) 31₂, a first feedback capacitor 31₃, a second feedback capacitor 31₄, an emitter resistor 31₅, a first coupling capacitor 31₆, a first base bias setting resistor 31₇, a second base bias setting resistor 31₈, a third base bias setting resistor 31₉, a first bypass capacitor 31₁₀, a second bypass capacitor 31₁₁, a second coupling capacitor 31₁₂, a load inductor 31₁₃, and a smoothing capacitor 31₁₄. Other than the above, the active circuit section 31 for oscillation has an abnormal oscillation suppressing circuit 36 comprising an inductor 36₁ and a resistor 36₂. The resonance circuit section 32 comprises an inductor 32₁ for resonance, a varactor diode 32₂, a d.c. blocking capacitor 32₃, a buffer inductor 32₄, a smoothing capacitor 32₅, and a coupling capacitor 32₆. In this case, the resonance frequency of the resonance circuit section 32 is set mainly by the resonance inductor 32₁ and the varactor diode 32₂.

The elements 31₁ to 31₁₄ and 36₁ and 36₂ constructing the active circuit section 31 for oscillation and the elements 32₁ to 32₅ constructing the resonance circuit section 32 are connected as shown in Fig. 3.

The known voltage controlled oscillator having the above construction operates as follows.

When a frequency setting voltage is supplied to the frequency setting voltage supply terminal 35, the frequency setting voltage is applied to the cathode of the varactor diode 32₂ via the buffer inductor 32₄ to set the capacitance value of the varactor diode 32₂ in correspondence with the magnitude of the frequency setting voltage. At this time, the resonance circuit section 32 resonates to a frequency determined by the inductance value of the resonance inductor 32₁ and the capacitance value of the varactor diode 32₂ which is set by the frequency setting voltage. When the active circuit section 31 for oscillation is seen from the resonance circuit section 32 in a state where the resonance circuit section 32 resonates, a negative resistance occurs in the active circuit section 31 for oscillation, so that a frequency signal equal to the resonance frequency is generated in the resonance circuit section 32. In the case of changing the frequency setting voltage to be supplied to the frequency setting voltage supply terminal 35, the capacitance value of the varactor diode 32₂ changes in correspondence with the change and the frequency of the frequency signal generated in the resonance circuit section 32 changes.

When the frequency signal equal to the resonance frequency is generated in the resonance circuit section 32, in the active circuit section 31 for oscillation, the first transistor 31₁ outputs the frequency signal as an oscillation signal from the emitter, which is supplied to the base of the second transistor 31₂ via the first coupling capacitor 31₆. The second transistor 31₂ amplifies the supplied oscillation signal by common-emitter connection and supplies the amplified oscillation signal from the collector to the oscillation signal output terminal 33 via the second coupling capacitor 31₁₂.

In this case, in the active circuit section 31 for oscillation, the abnormal oscillation suppressing circuit 36 in which the inductor 36₁ and the resistor 36₂ are connected in series is inserted in the d.c. circuit provided between the collector of the first transistor 31₁ and the emitter of the second transistor 31₂. The abnormal oscillation suppressing circuit 36 blocks an abnormal oscillation signal which is generated in a frequency band much lower than the oscillation frequency signal supplied from the collector of the first transistor 31₁ to the emitter of the second transistor 31₂. By connecting the abnormal oscillation suppressing circuit 36, the abnormal oscillation signal is prevented from being supplied from the collector of the second transistor 31₂ to the oscillation signal output terminal 33 via the second coupling capacitor 31₁₂.

In this case, preferably, the resistance value of the resistor 36₂ used for the abnormal oscillation suppressing circuit 36 is as low as possible since it is connected to the d.c. circuit. Usually, a resistor having a resistance value of 10 to 50 Ω is used.

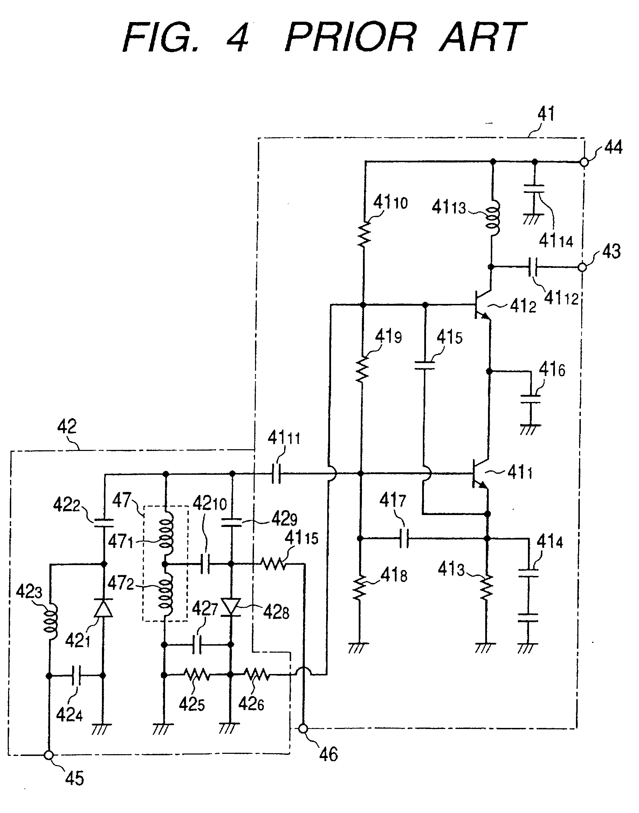

Fig. 4 is a circuit diagram showing an example of the construction of the known second voltage controlled oscillator.

As shown in Fig. 4, the known second voltage controlled oscillator comprises an active circuit section 41 for oscillation, a resonance circuit section 42, an oscillation signal output terminal 43, a power supply terminal 44, a frequency setting voltage supply terminal 45, and a band switching voltage supply terminal 46.

In this case, the active circuit section 41 for oscillation comprises: a first transistor (oscillation transistor) 41₁, a second transistor (amplification transistor) 41₂, an emitter resistor 41₃, a first emitter bypass capacitor 41₄, a first coupling capacitor 41₅, a second emitter bypass capacitor 416, a feedback capacitor 41₇, a first base bias setting resistor 41₈, a second base bias setting resistor 41₉, a third base bias setting resistor 41₁₀, a first coupling capacitor 41₁₁, a second coupling capacitor 41₁₂, a load inductor 41₁₃, a smoothing capacitor 41₁₄, and a buffer resistor 41₁₅. The resonance circuit section 42 comprises a varactor diode 42₁, a first d.c. blocking capacitor 42₂, a buffer inductor 42₃, a first bypass capacitor 42₄, a first voltage dividing resistor 42₅, a second voltage dividing resistor 42₆, a second bypass capacitor 42₇, a switching diode 42₈, a coupling capacitor 42₉, and a second d.c. blocking capacitor 42₁₀. Other than the above, the resonance circuit section 42 has an inductor 47 for resonance comprising a first inductor 47₁ and a second inductor 47₂ which are connected in series. In this case, the resonance frequency of the resonance circuit section 42 is set mainly by the resonance inductor 47 and the varactor diode 42₁.

The elements 41₁ to 41₁₅ constructing the active circuit section 41 for oscillation and the elements 42₁ to 42₁₀ and the elements 47₁ and 47₂ constructing the resonance circuit section 42 are connected as shown in Fig. 4.

The known second voltage controlled oscillator having the above construction operates as follows.

When a band switching voltage as a ground voltage is supplied to the band switching voltage supply terminal 46, the band switching voltage is applied to the anode of the switching diode 42₈ via the buffer resistor 41₁₅. At this time, since a required positive voltage has been supplied via the first and second voltage dividing resistors 42₅ and 42₆ to the cathode of the switching diode 42₈, the switching diode 42₈ is reverse-biased below cutoff. The resonance inductor 47 in the resonance circuit section 42 therefore enters a state in which the first inductor 47₁ and the second inductor 47₂ are connected in series and the resonance circuit section 42 resonates to a low frequency band. On the other hand, when a band switching positive voltage is supplied to the band switching voltage supply terminal 46, the band switching voltage is supplied to the anode of the switching diode 42₈. At this time, since the anode voltage of the switching diode 42₈ becomes larger than a voltage obtained by adding a junction voltage to the cathode voltage of the switching diode 42₈, the switching diode 42₈ is forward biased and is made conductive. Consequently, the resonance inductor 47 in the resonance circuit section 42 is short-circuited by the switching diode 42₈ which is made conductive by the second inductor 47₂ by passing alternating currents, so that a state where only the first inductor 47₁ is connected is obtained and the resonance circuit section 42 resonates to a high frequency band.

When the frequency setting voltage is supplied to the frequency setting voltage supply terminal 45, the frequency setting voltage is applied to the cathode of the varactor diode 42₁ via the buffer inductor 42₃ and the capacitance value of the varactor diode 42₁ is set in correspondence with the frequency setting voltage. At this time, the resonance circuit section 42 resonates to a frequency determined by: either the total inductance value of the first and second inductors 47₁ and 47₂ of the resonance inductor 47 (when the resonance circuit section 42 resonates to a low frequency band) or the inductance value of the first inductor 47₁ (when the resonance circuit section 42 resonates to a high frequency band) and the capacitance value of the varactor diode 42₁ which is set by the frequency setting voltage. When the frequency setting voltage to be supplied to the frequency setting voltage supply terminal 45 is changed, the capacitance value of the varactor diode 42₁ changes in correspondence with the change and the frequency of the frequency signal generated in the resonance circuit section 42 changes.

When a resonance frequency signal is generated in the resonance circuit section 42, in the active circuit section 41 for oscillation, the frequency signal is received by the base of the first transistor 41₁, outputted as an oscillation signal from the emitter, and supplied to the base of the second transistor 41₂ via the first coupling capacitor 41₅. The second transistor 41₂ amplifies the supplied oscillation signal by common-emitter connection and supplies the amplified oscillation signal from the collector to the oscillation signal output terminal 43 via the second coupling capacitor 41₁₂.

The known first voltage controlled oscillator has an advantage such that generation of the abnormal oscillation signal can be prevented and an oscillation signal in a predetermined frequency band can be outputted. On the other hand, since the abnormal oscillation suppressing circuit 36 in which the inductor 36₁ and the resistor 36₂ are connected in series is inserted in the active circuit section 31 for oscillation to suppress the abnormal oscillation signal, the number of parts used is larger as compared with other voltage controlled oscillators of this kind each in which the abnormal oscillation suppressing circuit 36 is not inserted, and the manufacturing cost is accordingly higher.

Since the large inductor 36₁ having a large volume is included in the abnormal oscillation suppressing circuit 36 which is newly inserted in the known first voltage controlled oscillator, it is difficult to reduce the size of the whole structure of the voltage controlled oscillator.

The known second voltage controlled oscillator has an advantage such that the generation of the abnormal oscillation signal can be prevented without connecting the abnormal oscillation suppressing circuit 36. On the other hand, since it is necessary to connect the first and second voltage dividing resistors 42₅ and 42₆, the bypass capacitor 42₇ and the like to the cathode side of the switching diode 42₈ in the resonance circuit section 42, the construction of the band switching type resonance circuit section 42 is complicated as a whole, the number of parts used increases, and the manufacturing cost accordingly rises.

The invention has been achieved in consideration of such a technical background and its object is to provide a voltage controlled oscillator which is prevented from generating an abnormal oscillation signal and realizes a small structure as a whole by reducing the number of parts used including a large part at a low manufacturing cost.

In order to achieve the object, according to the invention, there is provided a voltage controlled oscillator comprising: an oscillation transistor which operates by common-base connection and outputs an oscillation signal from the emitter; an amplification transistor which operates by common-emitter connection and whose base receives the oscillation signal; and a resonance circuit connected to the collector of the oscillation transistor, wherein in the resonance circuit, an inductor for resonance is connected in a d.c. circuit provided between the collector of the oscillation transistor and the emitter of the amplification transistor, and a capacitor for resonance is connected between the collector of the oscillation transistor and an earth point.

According to the construction, since the inductor for resonance constructing the resonance circuit which also serves as a power supply line is inserted in place of the abnormal oscillation suppressing circuit in the d.c. circuit provided between the collector of the oscillation transistor and the emitter of the amplification transistor, the resonance circuit can be constructed by the inductor for resonance and the capacitor for resonance and an abnormal oscillation signal can be prevented from being generated. By using at least the inductor for resonance while reducing the number of parts used in the voltage controlled oscillator, the number of parts of the abnormal oscillation suppressing circuit is reduced. Moreover, since one of the reduced parts is an inductor which is a large part, the whole structure of the voltage controlled oscillator can be made smaller than that of a known voltage controlled oscillator of this kind.

According to the invention, in the case of forming a band switching voltage controlled oscillator, preferably, a resonance frequency band of the resonance circuit is selectively switched to either a high band or a low band according to either one polarity or the other polarity of a band switching voltage and, when the resonance frequency band is switched to the high band, a part of the inductor for resonance or one of two inductors for resonance is short-circuited by passing alternating currents by the band switching voltage of the polarity.

With the construction, according to the polarity of the band switching voltage to be supplied, the whole inductor for resonance or only a part of the inductor is selectively used as a resonance circuit. Thus, the resonance frequency band of the resonance circuit can be selectively switched to either the high band or the low band relatively easily.

Further, according to the invention, in the case of constructing a band switching voltage controlled oscillator, it is preferable that a part of the inductor for resonance or one of the two inductors for resonance is short-circuited by passing alternating currents by a switching diode whose cathode is directly connected to one end of the inductor for resonance and whose anode is connected to a middle point of the inductor for resonance or a connection point of the two inductors for resonance via a capacitor.

With such a construction, it is unnecessary to connect a plurality of voltage dividing resistors and a bypass capacitors on the cathode side of the switching diode. Consequently, the construction of the band switching type voltage controlled oscillator is simplified, the reduction in the number of parts used and the miniaturization of the oscillator are achieved, and the manufacturing cost can be also reduced.

According to the invention, the inductor for resonance may take the form of a microstrip line.

With such a construction, the inductor for resonance can be miniaturized. Moreover, the resonance circuit can be made adapted to high frequency oscillation and the whole structure of the voltage controlled oscillator can be miniaturized.

Embodiments of the invention will now be described, by way of example only, with reference to the accompanying drawings, in which:
Fig. 1 is a circuit construction diagram showing an embodiment of a voltage controlled oscillator according to the invention.
Fig. 2 is a circuit construction diagram showing another embodiment of a voltage controlled oscillator according to the invention.
Fig. 3 is a circuit diagram showing an example of the construction of a known first voltage controlled oscillator.
Fig. 4 is a circuit diagram showing an example of the construction of a known second voltage controlled oscillator.

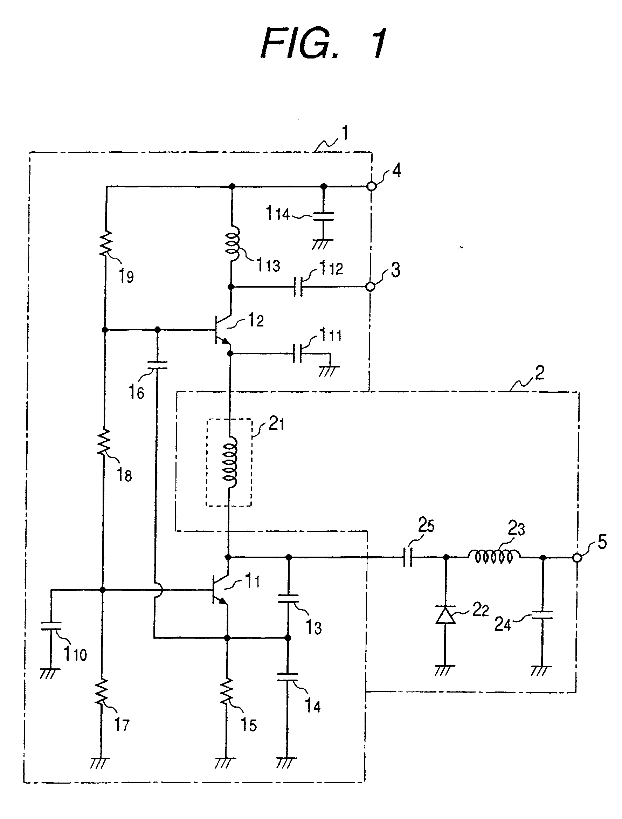

As shown in Fig. 1, the voltage controlled oscillator according to the embodiment comprises an active circuit section 1 for oscillation, a resonance circuit section 2, an oscillation signal output terminal 3, a power supply terminal 4, and a frequency setting voltage supply terminal 5.

In this case, the active circuit section 1 for oscillation comprises a first transistor (oscillation transistor) 1₁, a second transistor (amplification transistor) 12, a first feedback capacitor 1₃, a second feedback capacitor 1₄, an emitter resistor 1₅, a first coupling capacitor 1₆, a first base bias setting resistor 1₇, a second base bias setting resistor 1₈, a third base bias setting resistor 1₉, a first bypass capacitor 1₁₀, a second bypass capacitor 1₁₁, a second coupling capacitor 1₁₂, a load inductor 1₁₃, and a smoothing capacitor 1₁₄. The resonance circuit section 2 comprises an inductor 2₁ for resonance, a varactor diode 2₂, a buffer inductor 2₃, a smoothing capacitor 2₄, and a coupling capacitor 2₅. The resonance frequency of the resonance circuit section 2 is mainly set by the resonance inductor 2₁ and the varactor diode 2₂.

In the active circuit section 1 for oscillation, the load inductor 1₁₃, the collector-emitter path of the second transistor 1₂, the resonance inductor 2₁ in the resonance circuit section 2, the collector-emitter path of the first transistor 1₁, and the emitter resistor 1₅ are sequentially connected in series between the power supply terminal 4 and the earth point. In parallel with the series connection, the third base bias setting resistor 1₉, the second base bias setting resistor 1₈, and the first base bias setting resistor 1₇ are sequentially connected in series. The connection point between the third and second base bias setting resistors 1₉ and 1₈ is connected to the base of the second transistor 1₂. The connection point between the second and first base bias setting resistors 1₈ and 1₇ is connected to the base of the first transistor 1₁. The base of the first transistor 1₁ is connected to the earth point via the first bypass capacitor 1₁₀. The emitter of the first transistor 1₁ is connected to the base of the second transistor 1₂ via the second coupling capacitor 1₆. The collector of the first transistor 1₁ is connected to the coupling capacitor 2₅ in the resonance circuit section 2. Besides, in the first transistor 1₁, the first feedback capacitor 1₃ is connected between the collector and the emitter, and the second feedback capacitor 1₄ is connected between the emitter and the earth point. In the second transistor 1₂, the emitter is connected to the earth point via the second bypass capacitor 1₁₁ and the collector is connected to the oscillation signal output terminal 3 via the second coupling capacitor 1₁₂.

In the resonance circuit section 2, the cathode of the varactor diode 2₂ is connected to the active circuit section 1 for oscillation via the coupling capacitor 2₅ and to the frequency setting voltage supply terminal 5 via the buffer inductor 2₃. The anode of the varactor diode 2₂ is connected to the earth point. The smoothing capacitor 2₄ is connected between the frequency setting voltage supply terminal 5 and the earth point.

The voltage controlled oscillator having the above construction according to the embodiment operates as follows.

When a frequency setting positive voltage is supplied to the frequency setting voltage supply terminal 5, the frequency setting voltage is applied to the cathode of the varactor diode 2₂ via the buffer inductor 2₃. Since the anode of the varactor diode 2₂ has been connected to the earth point and an earth voltage is applied to the anode, the varactor diode 2₂ is reverse-biased and is set to a capacitance value corresponding to the frequency setting positive voltage supplied. At this time, the resonance circuit constructed by the resonance inductor 2₁ and the varactor diode 2₂ resonates to a frequency determined by the inductance value of the resonance inductor 2₁ and the set capacitance value of the varactor diode 2₂. When the active circuit section 1 for oscillation is seen from the resonance circuit section 2 in a state where the resonance circuit section 2 resonates, a negative resistance occurs in the active circuit section 1 for oscillation. An oscillation signal of a frequency equal to the resonance frequency of the resonance circuit section 2 is generated in the active circuit section 1 for oscillation. In the case where the frequency setting positive voltage to be supplied to the frequency setting voltage supply terminal 5 is changed, the capacitance value of the varactor diode 2₂ changes in correspondence with the changed frequency setting voltage, and the frequency of the resonance signal generated in the resonance circuit section 2 changes.

An oscillation signal generated in the active circuit section 1 for oscillation is outputted from the emitter of the first transistor 1₁ and is supplied to the base of the second transistor 1₂ via the first coupling capacitor 1₆. The second transistor 1₂ amplifies the supplied oscillation signal by common-emitter connection and supplies the amplified oscillation signal from the collector to the oscillation signal output terminal 3 via the second coupling capacitor 1₁₂.

In the voltage controlled oscillator in the embodiment, the resonance inductor 2₁ is connected in the d.c. circuit provided between the collector of the first transistor 1₁ and the emitter of the second transistor 1₂ in the active circuit section 1 for oscillation. In the case of using the resonance inductor 2₁ in the d.c. circuit as described above, an abnormal oscillation signal in a frequency band much lower than the oscillation frequency signal can be prevented from being generated. Moreover, it is unnecessary to use the resistor 36₂ of a small resistance value.

When the voltage controlled oscillator in the embodiment is compared with the known first voltage controlled oscillator shown in Fig. 3, by using the resonance inductor 2₁ in the former oscillator, not only a part of the components (resistor 36₂) of the abnormal oscillation suppressing circuit 36 in the latter oscillator but also a part (d.c. blocking capacitor 32₃) of components constructing the resonance circuit section 32 become unnecessary. The number of components used in the former oscillator is therefore smaller than that of the latter oscillator.

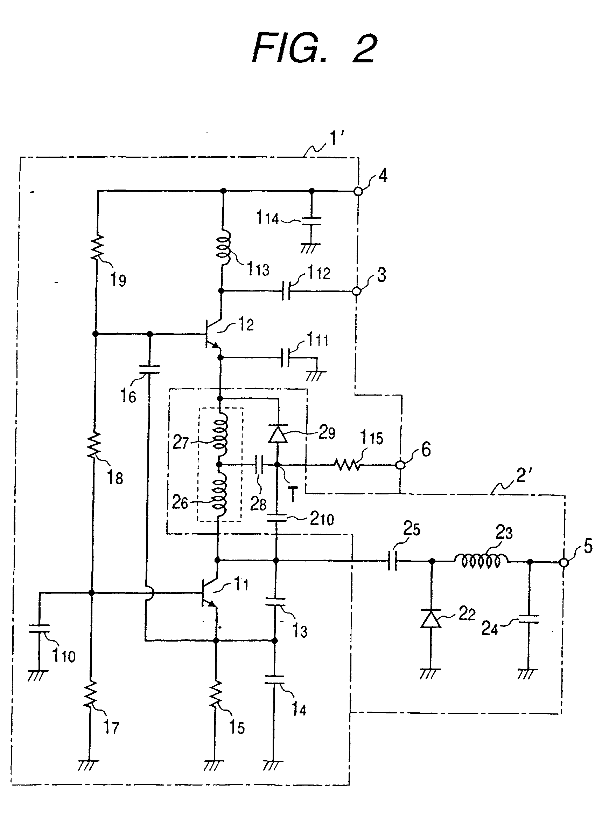

Fig. 2 is a circuit diagram showing another embodiment of a voltage controlled oscillator, and shows an example in which a band switching type resonance circuit is used as the resonance circuit section.

As shown in Fig. 2, a voltage controlled oscillator (hereinbelow, called a band switching type voltage controlled oscillator) in the embodiment comprises an active circuit section 1' for oscillation, a resonance circuit section 2', the oscillation signal output terminal 3, the power supply terminal 4, the frequency setting voltage supply terminal 5, and the band switching voltage supply terminal 6. When the voltage controlled oscillator in the embodiment is compared with the voltage controlled oscillator (called a single-band voltage controlled oscillator) in the embodiment of Fig. 1, the band switching voltage supply terminal 6 is newly provided. Further, as will be described hereinlater, the active circuit section 1 for oscillation and the resonance circuit section 2 are slightly modified, thereby obtaining the active circuit section 1' for oscillation and the resonance circuit section 2'.

In this case, in a manner similar to the active circuit section 1 for oscillation, the active circuit section 1' for oscillation comprises: the first transistor (oscillation transistor) 1₁, second transistor (amplification transistor) 1₂, first feedback capacitor 1₃, second feedback capacitor 1₄, emitter resistor 1₅, first coupling capacitor 1₆, first base bias setting resistor 1₇, second base bias setting resistor 1₈, third base bias setting resistor 1₉, first bypass capacitor 1₁₀, second bypass capacitor 1₁₁, second coupling capacitor 1₁₂, load inductor 1₁₃, and smoothing capacitor 1₁₄. Different from the active circuit section 1 for oscillation, the active circuit section 1' for oscillation further comprises a buffer resistor 1₁₅. In a manner similar to the resonance circuit section 2, the resonance circuit section 2' comprises the varactor diode 2₂, buffer inductor 2₃, smoothing capacitor 2₄, and coupling capacitor 2₅. The resonance circuit section 2' is different from the resonance circuit section 2 with respect to a point that the resonance inductor 2₁ which also serves as an abnormal oscillation suppressing circuit is replaced by a series circuit of a first resonance inductor 2₆ which also serves as an abnormal oscillation suppressing circuit and a second resonance inductor 2₇ and with respect to a point that the resonance circuit section 2' further comprises a first d.c. blocking capacitor 2₈, switching diode 2₉, and second d.c. blocking capacitor 2₁₀. In the case of a high band, the resonance frequency of the resonance circuit section 2' is set mainly by the first resonance inductor 2₆ and the varactor diode 2₂. In the case of a low band, the resonance frequency is set mainly by the series circuit of the first and second resonance inductors 2₆ and 2₇ and the varactor diode 2₂.

In the active circuit section 1' for oscillation, the buffer resistor 1₁₅ is connected between the band switching voltage supply terminal and the connection point T of the first d.c. blocking capacitor 2₈, the switching diode 2₉, and the second d.c. blocking capacitor 2₁₀ in the resonance circuit section 2'. In the resonance circuit section 2', the series circuit of the first and second resonance inductors 2₆ and 2₇ is connected between the collector of the first transistor 11 and the emitter of the second transistor 1₂. The d.c. blocking capacitor 2₈ is connected between the connection point of the first and second resonance inductors 2₆ and 2₇ and the connection point T. The cathode of the switching diode 2₉ is connected to the connection point of the second resonance inductor 2₇ and the emitter of the second transistor 1₂ and the anode of the switching diode 2₉ is connected to the connection point T. The coupling capacitor 2₁₀ is connected between the connection point T and the first resonance inductor 2₆ and the collector of the first transistor 1₁.

The operation of the band switching type voltage controlled oscillator having the construction is as follows.

When the band switching type voltage controlled oscillator is used as a voltage controlled oscillator in a low frequency band to output an oscillation signal in a low frequency band, a band switching voltage which is an earth voltage is supplied to the band switching voltage supply terminal 6. When the band switching voltage which is an earth voltage is supplied to the anode of the switching diode 2₉ via the buffer resistor 1₁₅, the cathode of the switching diode 2₉ is connected to the emitter of the second transistor 1₂. Since a required positive voltage has been supplied to the cathode, a reverse bias is applied to the switching diode 2₉ and a cutoff state is obtained. Consequently, in the resonance circuit section 2', the series circuit of the first and second resonance inductors 2₆ and 2₇ is connected as a resonance inductor, a state that the total inductance of the resonance inductors is large is obtained, and the resonance circuit in the resonance circuit section 2' resonates to a low frequency band.

On the other hand, when the band switching type voltage controlled oscillator is used as a voltage controlled oscillator in a high frequency band to output an oscillation signal in a high frequency band, a band switching positive voltage is supplied to the band switching voltage supply terminal 6. When the band switching positive voltage is supplied to the anode of the switching diode 2₉ via the buffer resistor 1₁₅, the anode voltage of the switching diode 2₉ becomes larger than a voltage obtained by adding the junction voltage of the diode 2₉ to the cathode voltage, the switching diode 2₉ is forward biased and enters an ON state. Consequently, in the resonance circuit section 2', the second resonance inductor 2₇ is short-circuited by passing alternating currents by the switching diode 2₉ in an ON state, a state in which only the first resonance inductor 2₆ is connected as the resonance inductor is obtained, the inductance of the resonance inductor is reduced, and the resonance circuit in the resonance circuit section 2' resonates to a high frequency band.

When a frequency setting positive voltage is supplied to the resonance frequency setting voltage supply terminal 5 in a state where the band switching type voltage controlled oscillator is switched to a low frequency band, the frequency setting positive voltage is supplied to the cathode of the varactor diode 2₂ via the buffer inductor 2₃, and an earth voltage is supplied to the anode of the varactor diode 2₂ by the connection to the earth point. Consequently, the varactor diode 2₂ is reverse-biased and is set to a capacitance value corresponding to the frequency setting voltage. At this time, the resonance circuit constructed by the series circuit of the first and second resonance inductors 2₆ and 2₇ and the varactor diode 2₂ resonates to frequencies in a low frequency band determined by the total inductance value of the first and second resonance inductors 2₆ and 2₇ and the capacitance value set in the varactor diode 2₂.

On the other hand, when the frequency setting positive voltage is supplied to the resonance frequency setting voltage supply terminal 5 in a state where the band switching type voltage controlled oscillator is switched to the high frequency band, the frequency setting positive voltage is supplied to the cathode of the varactor diode 2₂ via the buffer inductor 2₃, and an earth voltage is supplied to the anode of the varactor diode 2₂. Consequently, the varactor diode 2₂ is reverse-biased and is set to a capacitance value corresponding to the frequency setting voltage. At this time, the resonance circuit constructed by the first resonance inductor 2₆ and the varactor diode 2₂ resonates to frequencies in a high frequency band determined by the inductance value of the first resonance inductor 2₆ and the capacitance value set in the varactor diode 2₂.

The subsequent operation is the same as that of the signal-band voltage controlled oscillator irrespective of the case where the band switching type voltage controlled oscillator is switched to either the low frequency band or the high frequency band.

That is, when the active circuit section 1' for oscillation is seen from the resonance circuit section 2' in a state where the resonance circuit resonates, a negative resistance occurs in the active circuit section 1' for oscillation. Consequently, an oscillation signal of a frequency equal to the resonance frequency of the resonance circuit is generated in the active circuit section 1' for oscillation. In this case as well, when the frequency setting positive voltage to be supplied to the frequency setting voltage supply terminal 5 is changed, the capacitance value of the varactor diode 2₂ changes according to the changed frequency setting voltage and the frequency of the resonance signal generated in the resonance circuit section 2' changes.

The oscillation signal generated in the active circuit section 1' for oscillation is outputted from the emitter of the first transistor 1₁ and is supplied via the first coupling capacitor 1₆ to the base of the second transistor 1₂. The second transistor 1₂ amplifies the supplied oscillation signal by common emitter connection and supplies the amplified oscillation signal via the second coupling capacitor 1₁₂ to the oscillation signal output terminal 3.

In the band switching type voltage controlled oscillator as well, the resonance inductor which comprises the first and second resonance inductors 2₆ and 2₇ and also serves as the abnormal oscillation suppressing circuit is connected in the d.c. circuit provided between the collector of the first transistor 1₁ and the emitter of the second transistor 1₂ in the active circuit section 1' for oscillation. By using such a resonance inductor which also serves as the abnormal oscillation suppressing circuit, in a manner similar to the known abnormal oscillation suppressing circuit 36 which is made by the series circuit of the inductor 36₁ and the resistor 36₂ in the known first voltage controlled oscillator, the abnormal oscillation signal in the frequency band much lower than the oscillation frequency signal can be prevented from being generated and, moreover, it is unnecessary to use the resistor 36₂ of a small resistance value.

When the band switching type voltage controlled oscillator is compared with the known second voltage controlled oscillator shown in Fig. 4, in the former oscillator, by directly connecting the cathode of the switching diode 2₉ to the emitter of the second transistor 1₂ (an end of the second resonance inductor 2₇), the components (the first and second voltage dividing resistors 42₅ and 42₆ and the bypass capacitor 42₇ which are used in the latter oscillator) for applying a bias voltage to the cathode of the switching diode 42₈ become unnecessary. The number of components used in the former oscillator is therefore smaller than that of the latter oscillator.

Since each of the single-band voltage controlled oscillator and the band switching type voltage controlled oscillator generates an oscillation signal in a high frequency band in the foregoing embodiments, it is preferable to use an inductor for high frequencies such as a microstrip line as each of the resonance inductor 2₁, the first resonance inductor 2₆ and the second resonance inductor 2₇.

Although the case where the first and second resonance inductors 2₆ and 2₇ used in the band switching type voltage controlled oscillator are two separate resonance inductors has been described in the other embodiment, the resonance inductor of the invention is not limited to two separate resonance inductors but may be a single inductor having a center tap.

As described above, the resonance inductor constructing the resonance circuit is inserted in the d.c. circuit which is provided between the collector of the oscillation transistor and the emitter of the amplification transistor and the resonance inductor is also used as an inductor for the d.c. circuit. Thus, effects such that the resonance circuit can be constructed by the resonance inductor and the resonance capacitor and generation of an abnormal oscillation signal can be suppressed are produced.

The number of parts used in the voltage controlled oscillator can be reduced by an amount corresponding to at least the arrangement of using the resonance inductor also as the d.c. circuit. Moreover, since the omitted component is an inductor which is a large component, an effect such that the whole structure of the voltage controlled oscillator can be miniaturized as compared with the whole structure of the known first voltage controlled oscillator is produced.

Further, in the case of forming the band switching type voltage controlled oscillator, the following effects are produced. As compared with the whole structure of the known second voltage controlled oscillator, since it is unnecessary to connect a voltage dividing resistor and a bypass capacitor to the cathode of the switching diode, the construction of the band switching type voltage controlled oscillator is simplified, the number of parts used can be reduced, the size can be reduced, and the manufacturing cost can be reduced.

## Claims

1. A voltage controlled oscillator comprising:
an oscillation transistor (1₁) which operates by common-base connection and outputs an oscillation signal from the emitter;
an amplification transistor (1₂) which operates by common-emitter connection and whose base receives the oscillation signal; and
a resonance circuit (2, 2') connected to the collector of the oscillation transistor,
wherein in the resonance circuit, an inductor for resonance (2₁, 2₆, 2₇) is connected in a d.c. circuit provided between the collector of the oscillation transistor and the emitter of the amplification transistor, and a capacitor for resonance (2₂) is connected between the collector of the oscillation transistor and an earth point.

2. A voltage controlled oscillator according to claim 1, wherein a resonance frequency band of the resonance circuit is selectively switched to either a high band or a low band according to either one polarity or the other polarity of a band switching voltage (6) and, when the resonance frequency band is switched to the high band, a part of the inductor for resonance (2₁) or one of two inductors for resonance (2₇) is short-circuited by passing alternating currents by the band switching voltage of the polarity.

3. A voltage controlled oscillator according to claim 2, wherein a part of the inductor for resonance (2₁) or one of the two inductors for resonance (2₇) is short-circuited by passing alternating currents by a switching diode (2₉) whose cathode is directly connected to one end of the inductor for resonance and whose anode is connected to a middle point of the inductor for resonance or a connection point of the two inductors for resonance via a capacitor (2₈).

4. A voltage controlled oscillator according to claim 1, 2 or 3, wherein the inductor for resonance is a microstrip line.

## Patentansprüche

1. Spannungsgesteuerter Oszillator bestehend aus:
einem Oszillatortransistor (1₁), der in Basisschaltung arbeitet und am Emitter ein Oszillatorsignal ausgibt;
einem Verstärkertransistor (1₂), der in Emitterschaltung arbeitet und das Oszillatorsignal an der Basis empfängt; und
einer Resonanzschaltung (2, 2'), angeschlossen am Collector des Oszillatortransistors.
wobei in der Resonanzschaltung eine Resonanz- Induktivität (2₁, 2₆, 2₇) im Gleichstrompfad zwischen dem Collector des Oszillatortransistors und dem Emitter des Verstärkertransistors angeordnet ist und eine Resonanz- Kapazität (2₂) zwischen dem Collector des Oszillatortransistors und einem Erdpunkt angeschlossen ist.

2. Spannungsgesteuerter Oszillator nach Anspruch 1,
wobei ein Resonanzfrequenzband der Resonanzschaltung wahlweise umgeschaltet wird entweder zu einem hohen Band oder zu einem niedrigen Band entsprechend entweder einer Polarität oder der umgekehrten Polarität einer Bandumschaltspannung (6), und wenn das Resonanzband zu einem hohen Band umgeschaltet ist, ein Teil der Resonanz-Induktivität (2₁) oder eine von zwei Resonanz- Induktivitäten (2₇) kurzgeschlossen und für Wechselstrom leitend wird durch entsprechende Polarität der Bandumschaltspannung.

3. Spannungsgesteuerter Oszillator nach Anspruch 2, wobei ein Teil der Resonanz-Induktivität (2₁) oder eine von zwei Resonanz- Induktivitäten (2₇) kurzgeschlossen und für Wechselstrom leitend wird durch eine Schaltdiode (2₉), deren Kathode direkt mit einem Anschluß der Resonanz- Induktivität verbunden ist und deren Anode über einen Kondensator (2₈) an eine Mittenanzapfung der Resonanz- Induktivität oder einen Verbindungspunkt der zwei Resonanz- Induktivitäten verbunden ist.

4. Spannungsgesteuerter Oszillator nach Anspruch 1, 2 oder 3,
wobei die Resonanz- Induktivität eine Microstrip- Leitung ist.

## Revendications

1. Oscillateur commandé en tension, comprenant :
un transistor d'oscillation (1₁) qui fonctionne grâce à une connexion à base commune, et sort un signal d'oscillation de l'émetteur
un transistor d'amplification (1₂) qui fonctionne grâce à une connexion à émetteur commun, et dont la base reçoit le signal d'oscillation ; et
un circuit de résonance (2, 2') connecté au collecteur du transistor d'oscillation,
dans lequel, dans le circuit de résonance, un inducteur de résonance (2₁, 2₆, 2₇) est connecté dans un circuit en courant continu prévu entre le collecteur du transistor d'oscillation et l'émetteur du transistor d'amplification, et un condensateur de résonance (2₂) est connecté entre le collecteur du transistor d'oscillation et un point de la terre.

2. Oscillateur commandé en tension selon la revendication 1, dans lequel une bande de fréquence de résonance du circuit de résonance est commutée, de manière sélective, soit sur une bande haute, soit sur une bande basse, selon soit une polarité, soit l'autre polarité d'une tension de commutation de bandes (6) et, lorsque la bande de fréquence de résonance est commutée sur la bande haute, une partie de l'inducteur de résonance (2₁) ou l'un (2₇) de deux inducteurs de résonance est court-circuité par le passage de courants alternatifs grâce à la tension de commutation de bandes de la polarité.

3. Oscillateur commandé en tension selon la revendication 2, dans lequel une partie de l'inducteur de résonance (2₁) ou l'un des deux inducteurs de résonance (2₇) est court-circuité par le passage de courants alternatifs grâce à une diode de commutation (2₉) dont la cathode est directement connectée à une extrémité de l'inducteur de résonance, et dont l'anode est connectée en un point médian de l'inducteur de résonance ou en un point de connexion des deux inducteurs de résonance, par l'intermédiaire d'un condensateur (2₈).

4. Oscillateur commandé en tension selon la revendication 1, 2 ou 3, dans lequel l'inducteur de résonance est une ligne microruban.
